(19) **Europäisches Patentamt**
**European Patent Office**
**Office européen des brevets**

(11) **EP 3 944 274 A1**

(12) **DEMANDE DE BREVET EUROPEEN**

(43) Date de publication:
**26.01.2022 Bulletin 2022/04**

(21) Numéro de dépôt: **21186332.9**

(22) Date de dépôt: **19.07.2021**

(51) Classification Internationale des Brevets (IPC):
***H01H 1/00*** *(2006.01)*

(52) Classification Coopérative des Brevets (CPC):
**H01H 1/0015;** H01H 2071/044

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **20.07.2020 FR 2007607**

(71) Demandeur: **Schneider Electric Industries SAS 92500 Rueil-Malmaison (FR)**

(72) Inventeurs:
• **DELBAERE, Stéphane 38240 MEYLAN (FR)**
• **ORBAN, Rémy 38410 SAINT MARTIN D'URIAGES (FR)**

(74) Mandataire: **Lavoix 62, rue de Bonnel 69448 Lyon Cedex 03 (FR)**

(54) **PROCÉDÉS POUR ESTIMER UNE PROPRIÉTÉ D'UN APPAREIL DE COMMUTATION ÉLECTRIQUE, DISPOSITIFS POUR METTRE EN OEUVRE CES PROCÉDÉS**

(57) Ce procédé pour estimer une propriété d'un appareil de commutation électrique, comporte des étapes consistant à :
- détecter (100) un déplacement de contacts électriques (10, 14) de l'appareil de commutation au-delà d'un seuil d'ouverture ;
- mesurer (102), pour au moins une phase de l'appareil électrique, le courant électrique circulant dans cette phase ;
- évaluer (104), pour au moins une phase de l'appareil électrique, la tension électrique d'un arc électrique entre les contacts électriques associés à cette phase ;
- calculer (106), pour au moins ladite phase de l'appareil électrique, une valeur d'énergie associée à l'arc électrique, en intégrant numériquement le produit du courant électrique mesuré et de la tension électrique évaluée, l'intégration étant réalisée sur un intervalle de temps débutant à partir de la détection du déplacement des contacts électriques.

FIG.4

**Description**

La présente invention se rapporte à des procédés pour estimer une propriété d'un appareil de commutation électrique, ainsi qu'à des dispositifs associés pour mettre en œuvre ces procédés.

L'invention concerne plus particulièrement les contacteurs électriques comportant un actionneur électromagnétique comprenant une bobine.

De tels appareils de commutation électrique sont configurés pour commuter entre un état ouvert et un état fermé, par exemple pour commander l'alimentation électrique d'une charge électrique. Généralement, des contacts électriques mobiles sont liés à une partie mobile de l'actionneur qui se déplace sous l'effet d'un champ magnétique créé par la bobine lorsque celle-ci est parcourue par un courant électrique adéquat.

Il est souhaitable de pouvoir estimer automatiquement une ou plusieurs propriétés de l'appareil lorsqu'il est en fonctionnement, par exemple dans le but de connaître son état et/ou de détecter l'apparition de dysfonctionnements et ainsi prévoir une maintenance préventive adaptée.

Certains appareils comportent des capteurs dédiés pour mesurer des propriétés de l'appareil telles que la température ou l'état d'usure des contacts électriques. Cependant, ces capteurs renchérissent le coût de fabrication de l'appareil. De plus, il n'est pas toujours possible d'intégrer un nouveau capteur à un appareil existant.

C'est à ces inconvénients qu'entend plus particulièrement remédier l'invention en proposant des procédés pour estimer une ou plusieurs propriétés d'un appareil de commutation électrique.

A cet effet, un aspect de l'invention concerne un procédé pour estimer une propriété d'un appareil de commutation électrique, notamment une valeur d'énergie d'un arc électrique lors d'une phase d'ouverture de l'appareil, ce procédé comportant des étapes consistant à :

- détecter un déplacement de contacts électriques de l'appareil de commutation au-delà d'un seuil d'ouverture ;
- mesurer, pour au moins une phase de l'appareil électrique, le courant électrique circulant dans cette phase ;
- évaluer, pour au moins une phase de l'appareil électrique, la tension électrique d'un arc électrique entre les contacts électriques associés à cette phase ;
- calculer, pour au moins ladite phase de l'appareil électrique, une valeur d'énergie associée à l'arc électrique, en intégrant numériquement le produit du courant électrique mesuré et de la tension électrique estimée, l'intégration étant réalisée sur un intervalle de temps débutant à partir de la détection du déplacement des contacts électriques.

Grâce à l'invention, il est possible de déterminer facilement le niveau d'énergie de l'arc électrique survenant au niveau des contacts électriques lorsque ces derniers sont séparés à l'ouverture. Cette détermination est réalisée de façon simple pendant le fonctionnement de l'appareil, uniquement à partir de grandeurs obtenues par des mesures électriques et sans avoir besoin de capteur dédié.

L'information sur le niveau d'énergie de l'arc électrique peut avantageusement être ensuite utilisée pour estimer l'état d'usure des contacts électriques.

Selon des aspects avantageux mais non obligatoires, un tel procédé peut incorporer une ou plusieurs des caractéristiques suivantes, prises isolément ou suivant toute combinaison techniquement admissible :

- Une condition d'anomalie est identifiée si la valeur d'énergie dépasse un seuil prédéfini.
- La tension électrique est calculée à partir de la formule suivante : $U = 2(a + bx + \frac{c+dx}{I})$ où I est le courant électrique mesuré pour ladite phase de l'appareil électrique, x est le déplacement des contacts électriques de cette phase de l'appareil électrique et a, b, c et d sont des paramètres numériques.
- L'intervalle de temps est arrêté à l'expiration d'un délai prédéfini.
- Le délai prédéfini est égal à 50ms ou à 100ms.
- L'intervalle de temps est arrêté lorsque le courant électrique mesuré pour cette phase électrique atteint une valeur nulle.
- L'appareil de commutation est un contacteur comportant un actionneur électromagnétique.

Selon un autre aspect, un procédé pour estimer un état d'usure de contacts électriques d'un appareil de commutation électrique, comportant des étapes consistant à :

- estimer une valeur d'énergie associée à un arc électrique apparu entre des contacts électriques d'une phase de l'appareil lors d'une phase d'ouverture des contacts, au moyen d'un procédé conforme à l'invention ;
- calculer une valeur représentative d'un état d'usure des contacts électriques associés à cette phase électrique, ce calcul étant réalisé de façon itérative en incrémentant une valeur précédente avec une quantité dépendant de la valeur d'énergie calculée.

Selon un autre aspect, le courant électrique circulant et la tension électrique entre contacts électriques sont mesurés pour chaque phase de l'appareil électrique et dans lequel seule la phase électrique pour laquelle l'ouverture est détectée comme survenant en premier est prise en compte dans le calcul de l'usure.

Selon un autre aspect, appareil de commutation électrique, comportant un dispositif électronique de commande pour estimer une propriété de l'appareil de commutation électrique, notamment une valeur d'énergie d'un arc électrique lors d'une phase d'ouverture de l'appareil, le dispositif électronique de commande étant configuré pour :

- détecter un déplacement de contacts électriques de l'appareil de commutation au-delà d'un seuil d'ouverture ;
  mesurer, pour au moins une phase de l'appareil électrique, le courant électrique circulant dans cette phase ;
- évaluer, pour au moins une phase de l'appareil électrique, la tension électrique d'un arc électrique entre les contacts électriques associés à cette phase ;
  calculer, pour au moins ladite phase de l'appareil électrique, une valeur d'énergie associée à l'arc électrique, en intégrant numériquement le produit du courant électrique mesuré et de la tension électrique évaluée, l'intégration étant réalisée sur un intervalle de temps débutant à partir de la détection du déplacement des contacts électriques.

L'invention sera mieux comprise et d'autres avantages de celle-ci apparaîtront plus clairement à la lumière de la description qui va suivre d'un mode de réalisation d'un procédé donnée uniquement à titre d'exemple et faite en référence aux dessins annexés, dans lesquels :

[Fig 1] la figure 1 est une vue schématique d'un appareil de commutation électrique comportant un actionneur électromagnétique conforme à des modes de réalisation de l'invention ;
[Fig 2] la figure 2 une vue schématique d'un exemple du circuit de commande de l'actionneur électromagnétique de l'appareil de commutation de la figure 1 ;
[Fig 3] la figure 3 est un graphe représentant l'évolution d'un courant électrique de commande de l'actionneur électromagnétique de la figure 2 au cours de plusieurs phases de fonctionnement ;
[Fig 4] la figure 4 illustre l'évolution, en fonction du temps, pour un appareil de commutation triphasé conforme à des modes de réalisation, des courants électriques de chaque phase et des tensions électriques entre des conducteurs de phase amont et aval pour chaque phase électrique raccordée à l'appareil de commutation.
[Fig 5] la figure 5 est un exemple d'un procédé selon des modes de réalisation de l'invention.

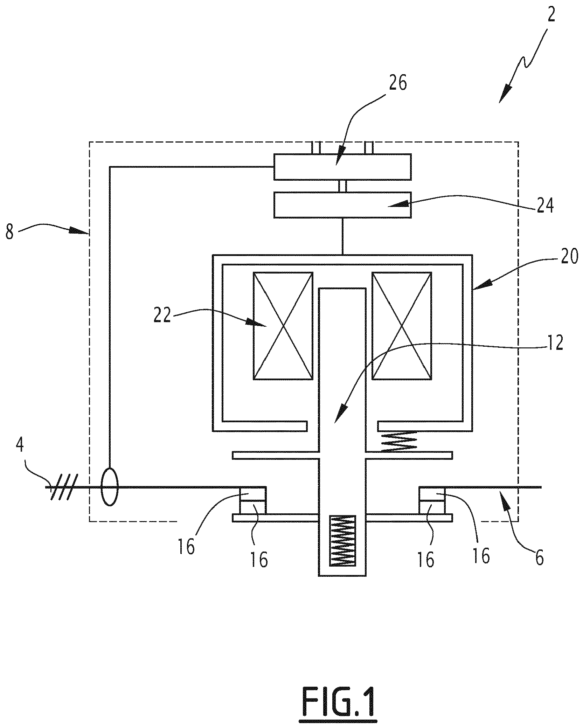

La figure 1 représente un appareil de commutation électrique 2, tel qu'un contacteur.

L'appareil 2 est configuré pour être commuté entre un état fermé dans lequel il laisse passer le courant électrique et un état ouvert dans lequel il empêche le passage d'un courant électrique.

Par exemple, l'appareil 2 peut être installé dans une installation électrique pour contrôler l'alimentation en électricité d'une charge électrique, telle qu'un moteur, par une source d'énergie électrique. La source d'énergie est, par exemple, un réseau d'alimentation électrique ou un générateur.

Dans l'exemple illustré, l'appareil 2 est relié, d'une part, à une ligne électrique amont 4 et, d'autre part, à une ligne électrique aval 6.

Les lignes électriques 4 et 6 peuvent comporter plusieurs phases électriques, par exemple pour acheminer un courant électrique alternatif triphasé. Quel que soit le nombre de phases, l'appareil 2 est configuré pour interrompre, ou alternativement autoriser la circulation, d'un courant électrique dans chacune des phases. Cependant, pour simplifier la figure 1, seul un conducteur de phase électrique est illustré pour chacune des lignes électriques 4 et 6.

L'appareil 2 comporte par exemple un boîtier 8.

Pour chaque phase électrique, l'appareil 2 comprend des contacts séparables 10, disposés sur une partie mobile 12, et des contacts fixes 14, liés aux lignes électriques amont 4 et aval 6. Chacun des contacts 10 et 14 comprend des pastilles de contact 16, réalisées ici en métal, de préférence en alliage d'argent ou tout matériau équivalent.

La partie mobile 12 de l'appareil 2 est déplaçable entre une position fermée, dans laquelle les contacts mobiles 10 sont en contact avec les contacts fixes 14, et une position ouverte, représentée sur la figure 1, dans laquelle les contacts mobiles 10 sont éloignés des contacts fixes 14.

L'appareil 2 comporte également un actionneur électromagnétique 20 configuré pour déplacer la partie mobile 12 entre la position de fermeture et la position d'ouverture.

L'actionneur électromagnétique 20 comporte une bobine 22 configurée pour générer un champ magnétique lorsqu'elle est alimentée par un courant électrique de commande, afin de mettre en mouvement la partie mobile 12.

Par exemple, la bobine 22 comporte un enroulement d'un fil électriquement conducteur. La partie mobile 12 peut être montée solidairement d'un noyau magnétique agencé coaxialement avec la bobine 22 et qui se déplace sous l'effet du champ magnétique généré par la bobine 22 lorsque celle-ci est excitée par injection d'un courant électrique approprié.

L'appareil 2 comporte en outre un circuit d'alimentation 24, configuré pour alimenter électriquement la bobine 12, et un dispositif électronique de commande 26 configuré pour piloter le circuit d'alimentation 24.

Dans de nombreux modes de réalisation, l'appareil 2 comprend une interface d'entrée, comportant par exemple des électrodes de commande, qui est configurée pour recevoir des ordres d'ouverture ou de fermeture en provenance d'un utilisateur. Par exemple, une tension électrique de commande peut être appliquée entre les électrodes de commande.

Dans de nombreux modes de réalisation, l'appareil 2 comprend aussi un capteur de courant 28 configuré pour mesurer un courant circulant dans chacune des phases de la ligne amont 4.

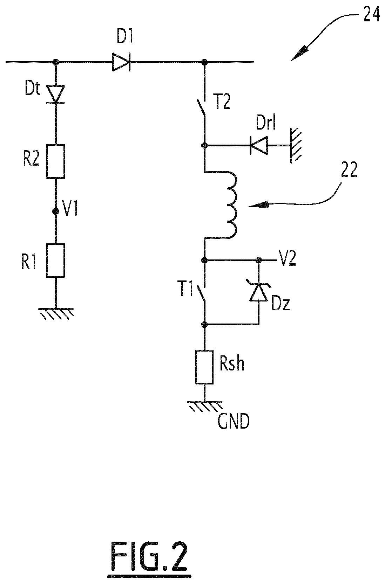

La figure 2 représente un mode de réalisation du circuit d'alimentation 24.

Dans l'exemple illustré, le circuit d'alimentation 24 comporte un rail d'alimentation électrique Vc adapté pour être alimenté électriquement soit par une alimentation extérieure, soit par le signal de commande reçu par l'appareil 2.

De préférence, le circuit d'alimentation 24 comprend un dispositif de mesure configuré pour mesurer la valeur de la tension électrique entre le rail d'alimentation Vc et une masse électrique GND du circuit 24.

Par exemple, le dispositif de mesure comprend deux résistances R1 et R2 connectées en série avec une diode Dt entre le rail d'alimentation Vc et la masse électrique GND. Un premier point de mesure, ici placé entre les résistances R1 et R2, permet de collecter une première tension de mesure V1 représentative de la tension électrique présente entre le rail d'alimentation Vc et la masse électrique GND.

Le circuit d'alimentation 24 comporte également un ou plusieurs interrupteurs de puissance connectés à la bobine 22 pour sélectivement connecter ou déconnecter la bobine 22 du rail d'alimentation Vc et de la masse GND.

Par exemple, un premier interrupteur T1 est connecté entre la bobine 22 et la masse GND. Un deuxième interrupteur T2 est connecté entre la bobine 22 et le rail d'alimentation Vc.

Par exemple, lorsque les deux interrupteurs T1 et T2 sont fermés, une tension électrique dépendant de la tension Vc est appliquée aux bornes de la bobine 22 et un courant électrique d'excitation circule dans la bobine 22. Lorsque seul le deuxième interrupteur T2 est ouvert, la bobine 22 peut se décharger et un courant électrique résiduel peut continuer à circuler temporairement dans la bobine 22.

Les interrupteurs T1 et T2 sont par exemple pilotés par le dispositif électronique de commande 26. Selon des exemples de mise en œuvre, les interrupteurs T1 et T2 sont des interrupteurs de puissance à semi-conducteurs, tels que des transistors Mosfet, ou des thyristors, ou des transistors bipolaires à grille isolée (IGBT), ou tout autre dispositif équivalent.

Dans l'exemple illustré, une diode Drl dite de roue libre est connectée entre le deuxième interrupteur T2 et la masse GND. Une diode Zéner Dz peut être connectée en parallèle du premier interrupteur T1. Une diode D1 peut être placée sur le rail d'alimentation Vc entre le deuxième interrupteur T2 et le dispositif de mesure pour éviter tout retour de courant vers ce dernier.

Dans de nombreux modes de réalisation, une résistance Rsh est connectée en série avec le premier interrupteur T1 pour collecter une deuxième tension de mesure V2 représentative du courant électrique qui circule dans la bobine 22.

L'architecture du circuit d'alimentation 24 n'est pas limitative et d'autres implémentations sont possibles.

De façon générale, le dispositif électronique de commande 26 est configuré pour assurer la commutation de l'appareil 2 lorsqu'il reçoit un ordre de commande approprié.

Avantageusement, le dispositif électronique de commande 26 est également configuré pour estimer au moins une propriété de l'appareil 2 pendant le fonctionnement de l'appareil 2, et notamment une ou plusieurs propriétés de la bobine 22, telles que la résistance de la bobine 22, l'inductance de la bobine 22 et la température de la bobine 22, comme cela sera mieux compris à la lecture de ce qui va suivre.

Dans de nombreux modes de réalisation, le dispositif électronique de commande 26 est implémenté par un ou plusieurs circuits électroniques.

Par exemple, le dispositif électronique de commande 26 comporte un processeur, tel qu'un microcontrôleur programmable ou un microprocesseur, et une mémoire informatique, ou tout support d'enregistrement de données lisible par ordinateur.

Selon des exemples, la mémoire est une mémoire ROM, ou une mémoire RAM, ou une mémoire non volatile du type EPROM ou Flash ou équivalent. La mémoire comporte des instructions exécutables et/ou du code informatique pour assurer le fonctionnement du dispositif de commande 26 conformément à un ou plusieurs des modes de réalisation décrits ci-après lorsqu'exécuté par le processeur.

Selon des variantes, le dispositif électronique de commande 26 peut comporter un processeur de traitement du signal (DSP), ou un composant logique reprogrammable (FPGA), ou un circuit intégré spécialisé (ASIC), ou tout élément équivalent.

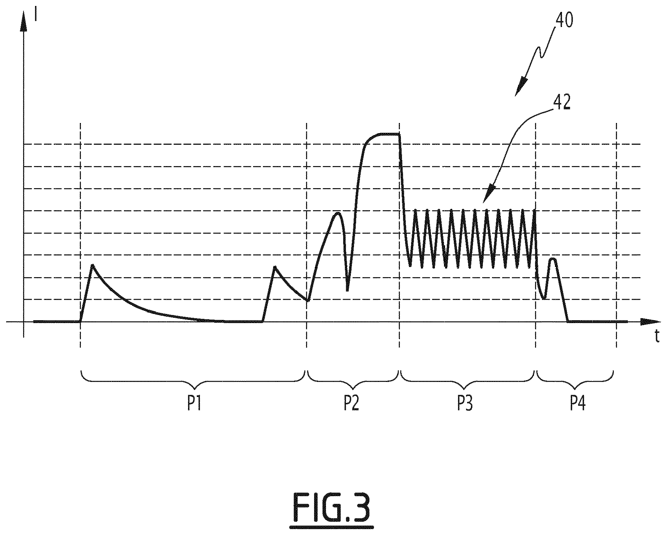

La figure 3 représente un graphique 40 illustrant l'évolution du courant électrique (I) circulant dans la bobine 22 au cours du temps (t) lors de différentes phases de fonctionnement successives de l'appareil 2, notées P1, P2, P3 et P4, dans le cas où l'appareil 2 est commuté vers l'état fermé, puis à nouveau commuté vers l'état ouvert. Ce courant électrique est nommé « courant bobine » dans ce qui suit.

La première phase P1 est une phase initiale, pendant laquelle l'appareil 2 est à l'état ouvert de façon stable. En pratique, le deuxième interrupteur T2 reste ouvert et le courant bobine reste nul.

Optionnellement, comme visible sur la figure, des impulsions de courant peuvent être injectées dans la bobine 22 à des fins d'estimation desdites propriétés.

La deuxième phase P2 correspond à une phase de fermeture, après qu'un ordre de fermeture ait été reçu par l'appareil 2. Par exemple, les interrupteurs T1 et T2 sont fermés. Le courant bobine augmente jusqu'à atteindre un seuil à partir duquel la partie mobile 12 commence à se déplacer de sa position ouverte vers sa position fermée. Dans la suite de la phase de fermeture, le courant bobine augmente jusqu'à une valeur plateau alors que les contacts mobiles 14 arrivent en appui sur les contacts fixes 10. L'appareil 2 est alors dans l'état fermé.

Lors d'une troisième phase P3, dite phase de maintien, le courant bobine reste maintenu au-dessus de la valeur de seuil. En pratique, le courant bobine peut, pendant cette phase de maintien, rester inférieur à la valeur plateau atteinte lors de la phase de fermeture.

Optionnellement, comme visible sur la figure, la tension bobine peut-être variée de manière périodique, de manière à réduire le plus possible l'intensité du courant bobine tout en le maintenant au-dessus dudit seuil, ceci afin d'éviter des déperditions d'énergie inutiles.

Dans l'exemple illustré, la variation périodique de la tension bobine est obtenue en ouvrant et fermant alternativement le deuxième interrupteur T2 avec une fréquence de hachage prédéfinie, ce qui crée des oscillations de la tension bobine suivant un profil prédéfini. En conséquence, le courant bobine présente également des oscillations 42 entre deux valeurs d'intensité. Pendant ce temps, le premier interrupteur T1 peut rester fermé.

Pour éviter que des vibrations mécaniques résultant de ces oscillations ne génèrent un bruit perceptible par l'oreille humaine, la fréquence de hachage est avantageusement choisie inférieure à 100 Hz, ou supérieure à 25 kHz. Dans l'exemple illustré, la fréquence de hachage est de 100 Hz.

La phase d'ouverture P4 commence lorsque le dispositif électronique de contrôle 26 reçoit un ordre d'ouverture. Les interrupteurs T1 et T2 sont tous deux ouverts.

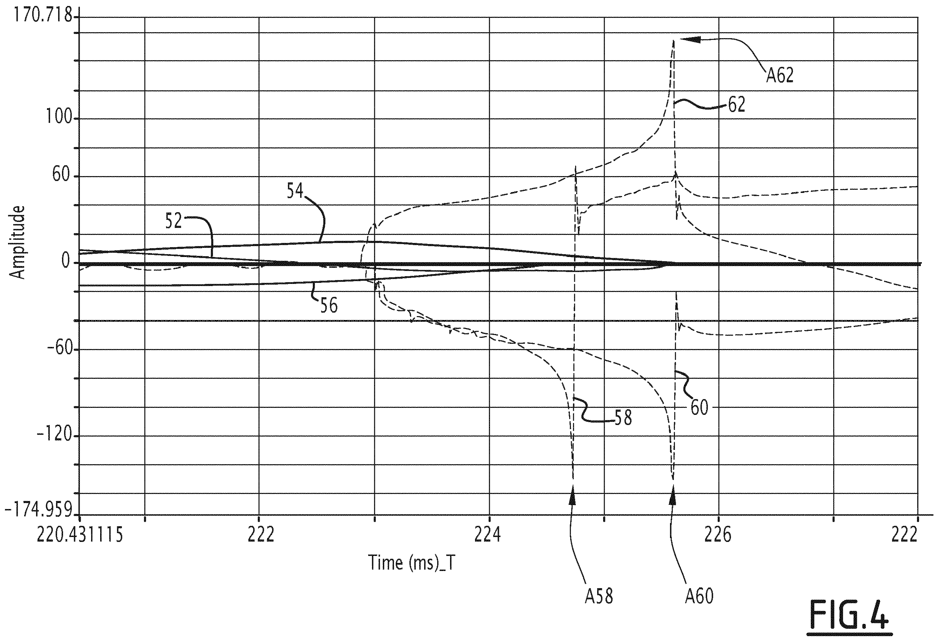

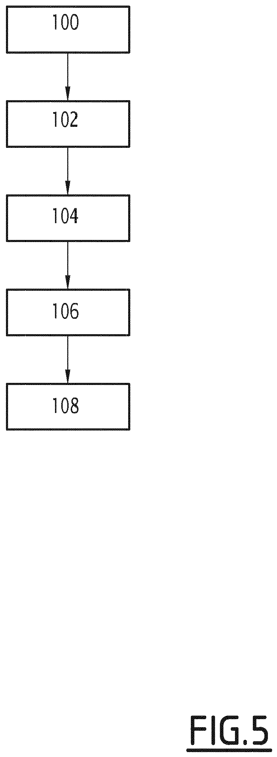

Un exemple de fonctionnement d'un procédé d'estimation de propriétés de l'appareil 2 est maintenant décrit en référence aux figures 4 et 5. Par exemple, ce procédé est mis en œuvre par le dispositif de commande 26.

Ce procédé est plus particulièrement applicable à la phase d'ouverture P4 décrite ci-dessus, pour estimer la quantité d'énergie libérée par un arc électrique qui apparaît entre les pastilles de contact 16 lorsque les contacts 10 et 14 sont séparés les uns des autres.

Plus généralement, ce procédé comporte des étapes consistant à :

- détecter un déplacement des contacts électriques 10, 14 au-delà d'un seuil d'ouverture (étape 100) ;
- mesurer, pour au moins une phase de l'appareil électrique, le courant électrique circulant dans cette phase (étape 102), c'est-à-dire le courant circulant entre les contacts électriques associés à cette phase ;
- évaluer, pour au moins une phase de l'appareil électrique, la tension électrique d'un arc électrique entre les contacts électriques associés à cette phase (étape 104) ;
- calculer, pour au moins ladite phase de l'appareil électrique, une valeur d'énergie associée à l'arc électrique, en intégrant numériquement le produit du courant électrique mesuré et de la tension électrique évaluée, l'intégration étant réalisée sur un intervalle de temps débutant à partir de la détection du déplacement des contacts électriques (étape 106).

Cependant, en variante, les étapes pourraient être exécutées dans un ordre différent. Certaines étapes pourraient être omises. L'exemple décrit ne fait pas obstacle à ce que, dans d'autres modes de réalisation, d'autres étapes soient mises en œuvre conjointement et/ou séquentiellement avec les étapes décrites.

La figure 4 illustre, pour un appareil de commutation 2 triphasé conforme à des modes de réalisation, l'évolution, en fonction du temps (axe des abscisses), des courants électriques de chaque phase (courbes 52, 54, 56, aussi nommés courants de phase) et des tensions électriques entre contacts fixe et mobile 10, 14 pour chaque phase (courbes 58, 60 et 62 respectivement).

Dans l'exemple illustré, les courbes de courant 52, 54 et 56 présentent une forme sinusoïdale et sont déphasées les unes par rapport aux autres. Pour interrompre le courant, l'appareil 2 est commuté vers l'état ouvert autour de l'instant t= 223ms. Dès cet instant, pour chaque phase, la tension électrique entre les pastilles de contact 16 augmente au fur et à mesure que le contact mobile 14 s'éloigne du contact fixe 10, cette tension indiquant la présence d'un arc électrique entre ces pastilles 16.

L'arc électrique est éventuellement interrompu pour chaque phase une fois que les contacts sont suffisamment éloignés et que le courant électrique de phase (qui est généralement périodique avec une forme sinusoïdale) passe par zéro. Alternativement, l'arc électrique peut être éteint lorsqu'il se déplace vers une chambre d'extinction d'arc de l'appareil 2.

L'extinction de l'arc électrique se traduit par la présence d'un pic de tension (notés A58, A60 et A62 pour les courbes 58, 60 et 62 respectivement). Sur les exemples illustrés, pour chaque phase, après l'apparition du pic de tension, la tension diminue pour devenir égale à la tension électrique du réseau, ici délivrée par la source d'énergie de l'installation électrique.

Le procédé décrit ci-dessus peut être démarré alors que l'appareil 2 est dans l'état fermé (par exemple dans la phase de fonctionnement P3 décrite ci-dessus), par exemple après que l'appareil 2 ait reçu un ordre d'ouverture.

Dans de nombreux modes de réalisation, la mesure de courant et la mesure de tension électrique peuvent être répétées au cours du temps, de préférence périodiquement.

Par exemple, chaque échantillonnage d'une valeur de la tension électrique est réalisé simultanément avec l'échantillonnage d'une valeur du courant électrique.

Les mesures de courant peuvent être réalisées avec le capteur de courant 28.

La mesure de courant et/ou la mesure de tension électrique peuvent également être déclenchées avant l'étape 100, par exemple dès la mise en route de l'appareil 2.

Avantageusement, lors de l'étape de calcul 104, la tension électrique U entre les contacts 10 et 14 de chaque phase électrique (ou pôle) de l'appareil 2 (ou, plus précisément, la tension entre les pastilles de contact 16 respectives des contacts 10 et 14) est calculée à partir de la formule suivante :

$$U = 2(a + bx + \frac{c+dx}{I})$$

où :

- I est le courant électrique mesuré pour ladite phase de l'appareil électrique,
- x est le déplacement des contacts électriques de cette phase de l'appareil électrique, et
- a, b, c et d sont des paramètres numériques, par exemple définis en fonction de propriétés de construction de l'appareil 2 et/ou de l'actionneur.

A titre d'exemple, en première approximation, la tension électrique U de l'arc peut être estimée égale à la somme des chutes de tension cathodique et anodique (chacune de l'ordre d'une quinzaine de volts), à laquelle s'ajoute une valeur additionnelle de tension qui est proportionnelle au déplacement x de la partie mobile 12. Cette valeur additionnelle de tension correspondant à la tension liée à l'allongement de l'arc, typiquement estimée égale à 3V/mm environ. Dans le cas courant d'une commutation à double coupure, la tension électrique U peut être comprise entre 30V et 50V.

Cette formule permet d'estimer la tension de l'arc électrique avec une bonne précision. D'autres formules peuvent cependant être utilisées pour calculer cette tension électrique.

Par exemple, le déplacement x est défini comme une variation de la position d'une partie mobile de l'actionneur 20 par rapport à une partie fixe de l'actionneur, telle que la bobine 22, cette partie mobile étant configurée pour se déplacer en translation par rapport à la bobine 22 le long d'un axe de déplacement. La partie mobile peut être un pont mobile portant le ou les contacts mobiles 14 associés à chaque phase électrique. En pratique, les contacts mobiles 14 de tous les pôles de l'appareil 2 se déplacement simultanément.

De préférence, ce déplacement x est calculé à partir d'estimations de la position des contacts mobiles 14 (ou, ici, de la partie mobile).

Par exemple, cette position peut être déterminée avec un capteur de position dédiée ou, de préférence, elle peut être estimée à partir de mesures de grandeurs électriques.

Selon un exemple possible, la position peut être estimée à partir d'une méthode comportant les étapes suivantes et pouvant être mise en œuvre par le dispositif de commande 26 :

a) après avoir reçu un ordre d'ouverture, commander l'ouverture de l'actionneur électromagnétique 20, par exemple en injectant un courant d'excitation dans la bobine 22 ;

b) pendant la commutation de l'appareil 2 vers l'état ouvert, mesurer et enregistrer les valeurs de tension aux bornes de la bobine ($U_{BOB}$) et le courant traversant la bobine ($I_{BOB}$) ;

c) calculer des valeurs d'un flux magnétique ($\phi$) traversant la bobine 22, par intégration des valeurs enregistrées du courant bobine, de la tension bobine et des valeurs de résistance ($R_{BOB}$) et d'inductance ($L_{B0B}$) de la bobine, ces valeurs de résistance et d'inductance étant précédemment connues, et pouvant par exemple être préalablement enregistrées dans le dispositif de commande 26 ;

d) à partir des valeurs de flux magnétique ($\phi$) et de courant bobine ($I_{BOB}$), évaluer et enregistrer des positions ($x$) d'un noyau de l'actionneur électromagnétique 20 en fonction d'une table de données caractéristique de l'actionneur électromagnétique, la table de données étant préalablement enregistrée dans le dispositif de commande 26 et définissant une relation bijective entre la position (*x*) du noyau, le flux magnétique (*ϕ*) et le courant bobine (I$_{BOB}$).

Par exemple, le noyau fait partie de la partie mobile 12 de l'appareil 2.

Dans ce qui précède, on définit un courant bobine I$_{BOB}$ comme étant un courant d'excitation circulant au travers de la bobine.

On définit un courant de décollage I$_D$ comme étant un seuil du courant bobine I$_{BOB}$ qui, lorsque l'actionneur 1 est à l'état ouvert, permet à l'actionneur 1 de se déplacer jusqu'à l'état fermé, dès que le courant bobine I$_{BOB}$ croit au-delà du courant de décollage I$_D$.

On définit un courant de décrochage I$_S$ - ou « *stall current* » en anglais - comme étant un seuil du courant bobine I$_{BOB}$ qui, lorsque l'actionneur 1 est à l'état fermé, permet à l'actionneur 1 de se déplacer jusqu'à l'état ouvert, dès que le courant bobine I$_{BOB}$ décroit en deçà du courant de décrochage I$_S$.

Par exemple, la valeur du flux magnétique *ϕ* est liée aux valeurs de tension bobine UBOB et de courant bobine I$_{BOB}$ selon l'équation suivante, notée Math 1 dans ce qui suit :

$$U_{BOB} = R_{BOB} \cdot I_{BOB} + N \frac{d\phi}{dt} \qquad [Math\ 1]$$

dans laquelle N est le nombre de spires de la bobine 22, et *ϕ* est le flux magnétique traversant chaque spire de la bobine 22.

En dérivant *ϕ* dans l'équation Math 1, on obtient une équation générale Math 2 régissant les grandeurs électromagnétiques dans l'actionneur 1 :

$$U_{BOB} = R_{BOB} \cdot I_{BOB} + N \frac{d\phi}{dI_{BOB}} \frac{dI_{BOB}}{dt} + N \frac{d\phi}{dx} \frac{dx}{dt} + N \frac{d\phi}{di_f} \frac{di_f}{dt} \quad [Math\ 2]$$

dans laquelle le dernier terme $N \frac{d\phi}{di_f} \frac{di_f}{dt}$ fait intervenir des courants d'induction, aussi dits courants de Foucault, notés $i_f$.

Les courants induits étant négligés, le circuit magnétique présente une reluctance *Rel* qui est, d'une part, fonction de la position *x* du noyau mobile (de la partie mobile 12) et du courant bobine I$_{BOB}$, et qui est, d'autre part, liée au flux magnétique *ϕ* et au courant bobine I$_{BOB}$ par la relation suivante $Rel(x,I_{BOB}) \cdot \phi = N \cdot I_{BOB}$.

Autrement dit, le flux magnétique *ϕ* est une fonction de la position *x* et du courant bobine I$_{BOB}$, le flux magnétique *ϕ* pouvant être exprimé sous la forme d'une relation analytique, ou bien, pour une meilleure précision, par une surface de réponse bidimensionnelle générée par des outils de simulation du circuit magnétique de l'appareil 2.

Dans la grande majorité des cas, la surface $\phi = f(x,I_{BOB})$ présente un caractère bijectif, c'est-à-dire que pour un courant bobine I$_{BOB}$ donnée, à une valeur donnée de la position x correspond une unique valeur de flux magnétique *ϕ*. Ceci permet de reconstruire une fonction inverse $x = g(\phi,I_{BOB})$ donnant la valeur de la position *x* en fonction du flux magnétique *ϕ* et du courant bobine I$_{BOB}$.

La surface $\phi = f(x, I_{BOB})$, ou bien sa fonction inverse $x = g(\phi, I_{BOB})$, est enregistrée dans la mémoire du dispositif de commande 26, par exemple sous la forme d'une table de données caractéristique de l'actionneur électromagnétique, la table de données définissant une relation bijective entre la position *x* du noyau, le flux bobine *ϕ* et le courant bobine I$_{BOB}$.

Le flux magnétique *ϕ* est aussi donné par intégration temporelle de l'équation Math 1. On obtient alors l'équation Math 3 ci-dessous :

$$\phi(t) = \int \frac{U_{BOB} - R_{BOB} \cdot I_{BOB}}{N} \cdot dt + \phi_0 \quad [Math\ 3]$$

dans laquelle U$_{BOB}$ et I$_{BOB}$ sont mesurés, N, *dt* et R$_{BOB}$ sont connus et $\phi_0$ est une valeur initiale du flux magnétique *ϕ*, au début de l'intervalle d'intégration. Dans le cadre de la présente invention, l'intervalle d'intégration commence de préférence au moment où le dispositif de commande 26 commande l'ouverture de l'actionneur, c'est-à-dire à l'instant $t_2'$.

Le flux magnétique *ϕ* peut être calculé à partir de l'équation Math 3 selon des méthodes de calcul numérique mises en œuvre par le dispositif électronique de contrôle 40.

Plus l'intervalle temporel d'intégration *dt* est petit, autrement dit plus le pas d'intégration est court, et plus réduite est l'erreur de calcul. L'intervalle *dt* est par exemple proportionnel à l'inverse d'une fréquence d'horloge de l'unité logique de calcul du dispositif électronique de contrôle 40. Selon des exemples, la fréquence d'horloge du dispositif 40 est de 1 kHz.

Afin de calculer le flux $\phi$ par intégration des mesures de $U_{BOB}$ et $I_{BOB}$ et de remonter, à l'aide de la fonction inverse $x = g(\phi, I_{BOB})$, à l'évolution de la position $x$ du noyau mobile, il convient de déterminer le flux initial $\phi_0$. On définit une estimée du flux initial $\hat{\phi}_0$.

Une méthode pour y parvenir, dite méthode d'autocorrection, repose sur le fait que le noyau mobile reste immobile en position fermée au cours de la phase d'ouverture P4 tant que le courant bobine $I_{BOB}$ est supérieur au courant de décrochage $I_S$, c'est-à-dire avant l'instant $t_2''$ de décrochage, tant que le noyau est immobile en position fermée.

Autrement dit, à chaque instant $t$ compris entre $t_2'$ et $t_2''$ (où $t_2'$ est l'instant où le dispositif 26 commande l'ouverture de l'appareil 2), tant que le courant bobine $I_{BOB}$ est supérieur au courant de décrochage $I_S$, lorsque le flux magnétique $\phi$ est calculé à l'aide de l'équation Math 3 et que la position $x$ à l'instant $t$ en est déduite à l'aide de la fonction inverse $x = g(\phi, I_{BOB})$, si la position calculée n'est pas constante, autrement dit $x(t) \neq x(t_2')$, c'est qu'il y a une erreur sur l'estimée de flux initial $\hat{\phi}_0$.

Le flux magnétique $\phi$ à l'instant $t$ est alors compensé pour corriger cette erreur, cette compensation se traduisant par une ré-estimation du flux initial $\hat{\phi}_0$. La correction du flux $\phi$ est appliquée plusieurs fois, au cours de plusieurs calculs successifs et tant que l'instant $t$ compris entre $t_2'$ et $t_2''$, jusqu'à convergence de l'estimée de flux initial $\hat{\phi}_0$ et du flux réel $\phi_0$. En résultat de la méthode d'autocorrection, l'erreur sur le flux initial $\phi_0$ est compensée de manière précise.

Ainsi, lorsque le courant bobine $I_{BOB}$ décroît en deçà du courant de décrochage $I_S$ et que le noyau commence à bouger, la connaissance précise du flux magnétique $\phi$ permet à son tour de calculer la position x de manière précise.

En variante, la position pourrait être estimée différemment.

A la fin de l'étape 104, on dispose ainsi d'une estimation du déplacement x, ou de façon équivalente, de la position des contacts électriques.

Lors de l'étape 106, l'intégration est réalisée sur un intervalle de temps débutant à partir de la détection du déplacement des contacts électriques.

De préférence, l'intervalle débute en fait lorsque le déplacement a atteint une valeur de garde à l'écrasement, sans pour autant que les contacts électriques mobiles 14 se soient séparés des contacts fixes 10.

En pratique, l'intervalle de temps prend fin lorsque l'arc électrique s'est éteint, ou lorsque l'arc électrique s'est déplacé vers une chambre d'extinction d'arc de l'appareil 2.

Avantageusement, ledit intervalle de temps est arrêté à l'expiration d'un délai prédéfini. Par exemple, le délai prédéfini est égal à 50ms ou à 100ms.

Ces valeurs permettent de garantir que, dans la plupart des situations, l'arc électrique se sera éteint à l'expiration du délai prédéfini.

Par exemple, le délai prédéfini peut correspondre à au moins cinq fois la demi période du courant de phase, l'appareil 2 étant configuré pour interrompre le courant au bout de deux ou trois demi périodes du courant de phase.

Dans des modes de réalisation alternatifs, ledit intervalle de temps prend fin lorsque le courant électrique mesuré pour cette phase électrique atteint une valeur nulle, par exemple lorsque le capteur de courant 28 détecte un courant durablement nul dans la phase correspondante.

Avantageusement, le procédé décrit ci-dessus peut être utilisé pour estimer un état d'usure des contacts électriques 10, 14 de l'appareil 2, et plus particulièrement l'état d'usure des pastilles de contact 16.

En effet, en pratique, lors de chaque ouverture des contacts 10 et 14, l'arc électrique endommage peu à peu les pastilles de contact 16 par ablation de matière. Dans certains cas, les pastilles de contact 16 peuvent être endommagées au point de nuire au bon fonctionnement de l'appareil 2, par exemple parce qu'elles ont changé de forme ou que leur épaisseur a diminué au point de ne plus assurer un contact électrique de bonne qualité dans l'état fermé.

De préférence, l'estimation de l'état d'usure des contacts électriques 10, 14 est réalisée à partir de la valeur d'énergie

Ainsi, dans certains modes de réalisation, lors d'une étape 108, postérieure à l'étape 106, une valeur représentative d'un état d'usure des contacts électriques 14 associés à cette phase électrique est automatiquement calculée. De préférence, ce calcul est réalisé de façon itérative en incrémentant une valeur précédente avec une quantité dépendant de la valeur d'énergie calculée lors de l'étape 106.

De préférence, une valeur représentative d'un état d'usure est définie pour chacune des phases de l'appareil 2. Chacune de ces valeurs est incrémentée lors de l'ouverture des contacts, avec la valeur d'énergie d'arc estimée pour la phase électrique correspondante.

Par exemple, cette valeur représentative d'un état d'usure est enregistrée, de préférence pour chacune des phases électriques, dans une mémoire du dispositif de commande 24. Une valeur initiale de la une valeur représentative d'un état d'usure peut être préenregistrée en mémoire, par exemple en usine.

Ainsi, l'état d'usure des contacts électriques 10, 14 est mis à jour lors de chaque commutation de l'appareil 2 vers l'état ouvert.

Si la valeur cumulative d'au moins une des phases dépasse un seuil d'alerte préenregistré, alors une condition d'anomalie est automatiquement identifiée.

Par exemple, un message d'alerte peut être envoyé à un utilisateur distant et/ou être affiché sur un écran d'affichage de l'appareil 2 ou au moyen d'un témoin lumineux de l'appareil 2.

Ainsi, il est possible de détecter facilement une usure de l'appareil 2. La mise en œuvre d'opérations de maintenance préventive s'en trouve donc facilitée.

Optionnellement, le courant électrique circulant et la tension électrique entre contacts électriques sont mesurés pour chaque phase de l'appareil électrique et seule la phase électrique pour laquelle l'ouverture est détectée comme survenant en premier est prise en compte dans le calcul de l'usure.

Cela permet à un opérateur d'intervenir plus rapidement dès l'apparition d'une usure significative sur au moins un des pôles, sans attendre une dégradation complète des autres pôles. En effet, dans certaines installations électriques et/ou dans certaines circonstances, l'arc électrique peut apparaître en premier sur une phase spécifique, avant que des arcs électriques n'apparaissent sur les autres phases, du fait du déphasage des courants entre les phases notamment. De fait, certains pôles s'usent plus rapidement que d'autres.

Avantageusement, une condition d'anomalie peut aussi être identifiée si la valeur d'énergie estimée pour une phase électrique de l'appareil 2 lors de l'étape 106 dépasse un seuil prédéfini. Cela permet de détecter une situation dans laquelle l'arc électrique dégagerait tellement d'énergie lors d'une commutation à l'ouverture qu'il en endommagerait les pastilles de contact 16.

Toute caractéristique de l'un des modes de réalisation ou variante décrite ci-dessus, peut être mise en œuvre dans les autres modes de réalisation et variantes décrits.

**Revendications**

1. Procédé pour estimer une propriété d'un appareil de commutation électrique (2), notamment une valeur d'énergie d'un arc électrique lors d'une phase d'ouverture de l'appareil, ce procédé comportant des étapes consistant à :

   - détecter (100) un déplacement de contacts électriques (10, 14) de l'appareil de commutation au-delà d'un seuil d'ouverture ;
   - mesurer (102), pour au moins une phase de l'appareil électrique, le courant électrique circulant dans cette phase ;
   - évaluer (104), pour au moins une phase de l'appareil électrique, la tension électrique d'un arc électrique entre les contacts électriques associés à cette phase ;
   - calculer (106), pour au moins ladite phase de l'appareil électrique, une valeur d'énergie associée à l'arc électrique, en intégrant numériquement le produit du courant électrique mesuré et de la tension électrique évaluée, l'intégration étant réalisée sur un intervalle de temps débutant à partir de la détection du déplacement des contacts électriques.

2. Procédé selon la revendication 1, dans lequel une condition d'anomalie est identifiée si la valeur d'énergie dépasse un seuil prédéfini.

3. Procédé selon la revendication 1 ou la revendication 2, dans lequel la tension électrique est calculée à partir de la formule suivante : $U = 2(a + bx + \frac{c+dx}{I})$ où I est le courant électrique mesuré pour ladite phase de l'appareil électrique, x est le déplacement des contacts électriques de cette phase de l'appareil électrique et a, b, c et d sont des paramètres numériques.

4. Procédé selon l'une quelconque des revendications précédentes, dans lequel ledit intervalle de temps est arrêté à l'expiration d'un délai prédéfini.

5. Procédé selon la revendication 4, dans lequel le délai prédéfini est égal à 50ms ou à 100ms.

6. Procédé selon l'une quelconque des revendications 1 à 3, dans lequel ledit intervalle de temps est arrêté lorsque le courant électrique mesuré pour cette phase électrique atteint une valeur nulle.

7. Procédé selon l'une quelconque des revendications précédentes, dans lequel l'appareil de commutation est un contacteur comportant un actionneur électromagnétique.

8. Procédé pour estimer un état d'usure de contacts électriques d'un appareil de commutation électrique (2), comportant des étapes consistant à :

- estimer (100, 102, 104, 106) une valeur d'énergie associée à un arc électrique apparu entre des contacts électriques d'une phase de l'appareil lors d'une phase d'ouverture des contacts, au moyen d'un procédé conforme à l'une quelconque des revendications précédentes ;
- calculer (108) une valeur représentative d'un état d'usure des contacts électriques associés à cette phase électrique, ce calcul étant réalisé de façon itérative en incrémentant une valeur précédente avec une quantité dépendant de la valeur d'énergie calculée.

9. Procédé selon la revendication précédente, dans lequel le courant électrique circulant et la tension électrique entre contacts électriques sont mesurés pour chaque phase de l'appareil électrique et dans lequel seule la phase électrique pour laquelle l'ouverture est détectée comme survenant en premier est prise en compte dans le calcul de l'usure.

10. Appareil de commutation électrique (2), comportant un dispositif électronique de commande (26) pour estimer une propriété de l'appareil de commutation électrique, notamment une valeur d'énergie d'un arc électrique lors d'une phase d'ouverture de l'appareil, le dispositif électronique de commande (26) étant configuré pour :

- détecter (100) un déplacement de contacts électriques (10, 14) de l'appareil de commutation au-delà d'un seuil d'ouverture ;
- mesurer (102), pour au moins une phase de l'appareil électrique, le courant électrique circulant dans cette phase ;
- évaluer (104), pour au moins une phase de l'appareil électrique, la tension électrique d'un arc électrique entre les contacts électriques associés à cette phase ;
- calculer (106), pour au moins ladite phase de l'appareil électrique, une valeur d'énergie associée à l'arc électrique, en intégrant numériquement le produit du courant électrique mesuré et de la tension électrique évaluée, l'intégration étant réalisée sur un intervalle de temps débutant à partir de la détection du déplacement des contacts électriques.

FIG.1

## FIG.2

FIG.3

FIG.4

EP 3 944 274 A1

```
┌─────────────────────┐
│         100         │
└─────────────────────┘
           │
           ▼
┌─────────────────────┐
│         102         │
└─────────────────────┘
           │
           ▼
┌─────────────────────┐
│         104         │
└─────────────────────┘
           │
           ▼
┌─────────────────────┐
│         106         │
└─────────────────────┘
           │
           ▼
┌─────────────────────┐
│         108         │
└─────────────────────┘
```

FIG.5

Europäisches
Patentamt

European
Patent Office

Office européen
des brevets

# RAPPORT DE RECHERCHE EUROPEENNE

**Numéro de la demande**

**EP 21 18 6332**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2001/019573 A1 (DOUGHERTY JOHN J [US] ET AL) 6 septembre 2001 (2001-09-06) * alinéas [0019] - [0040]; figures * ----- | 1-10 | INV. H01H1/00 |
| A | EP 3 340 262 A1 (EATON CORP [US]) 27 juin 2018 (2018-06-27) * alinéas [0014] - [0027]; figures * ----- | 1,10 | |
| A | EP 1 475 813 A1 (ABB TECHNOLOGY AG [CH]) 10 novembre 2004 (2004-11-10) * alinéas [0006], [0007]; figures * ----- | 1,10 | |

**DOMAINES TECHNIQUES RECHERCHES (IPC)**

H01H

Le présent rapport a été établi pour toutes les revendications

| Lieu de la recherche | Date d'achèvement de la recherche | Examinateur |
|---|---|---|
| **Munich** | **14 décembre 2021** | **Findeli, Luc** |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..............................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 21 18 6332

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-12-2021

| Document brevet cité au rapport de recherche | | Date de publication | Membre(s) de la famille de brevet(s) | | Date de publication |
|---|---|---|---|---|---|
| US 2001019573 | A1 | 06-09-2001 | DE 10204849 | A1 | 22-08-2002 |
| | | | US 2001019573 | A1 | 06-09-2001 |
| EP 3340262 | A1 | 27-06-2018 | CN 108226769 | A | 29-06-2018 |
| | | | EP 3340262 | A1 | 27-06-2018 |
| | | | US 2018172767 | A1 | 21-06-2018 |
| EP 1475813 | A1 | 10-11-2004 | AT 456853 | T | 15-02-2010 |
| | | | EP 1475813 | A1 | 10-11-2004 |
| | | | ES 2338543 | T3 | 10-05-2010 |
| | | | US 2004223276 | A1 | 11-11-2004 |

EPO FORM P0460

Pour tout renseignement concernant cette annexe : voir Journal Officiel de l'Office européen des brevets, No.12/82